# FASCICULE DE BREVET EUROPEEN

(11) **EP 0 466 617 B1**
(45) Date de publication et mention de la délivrance du brevet: **25.05.1994**
(21) Numéro de dépôt: 91420231.2
(22) Date de dépôt: 08.07.1991
(51) Int. Cl.: C23C 14/34, C22F 1/043

(54) **Procédé de fabrication de cathodes pour pulvérisation cathodique à base d'aluminium de très haute pureté**
Verfahren zur Herstellung von hochreinen Kathoden auf Aluminiumbasis für Kathodenzerstäubung
Process for the production of high purity aluminium-based cathodes for cathodic sputtering

(30) Priorité: 10.07.1990 FR 9009397
(43) Date de publication de la demande: 15.01.1992
(73) Titulaire: ALUMINIUM PECHINEY, 92400 Courbevoie (FR)
(72) Inventeur: Legresy, Jean-Marc, F-38120 St Egreve (FR); Marticou, Marc-Henri, F-09000 Foix (FR)
(74) Mandataire: Jacquet, Michel

(56) Documents cités:
- GB-A- 2 164 280
- PATENT ABSTRACTS OF JAPAN, vol. 10, no. 314 (C-380)[2370], 24 octobre 1986; & JP-A-61 124 566
- PATENT ABSTRACTS OF JAPAN, vol. 12, no. 433 (C-543)[3280], 15 novembre 1988; & JP-A-63 161 161

## Description

### EXPOSE DU PROBLEME

L'invention concerne un procédé de fabrication de cibles ou cathodes en alliage aluminium-silicium destinés à la pulvérisation cathodique sur un substrat.
Le procédé de pulvérisation cathodique est décrit, par exemple, dans les "Techniques de l'ingénieur"(M 1657-2) à qui ce qui suit est emprunté:
"La pulvérisation cathodique est un procédé de dépôt sous vide fonctionnant à froid, en plasma luminescent, dans un gaz maintenu à pression réduite (10⁻¹ à 10² Pa). Il permet de déposer tous les types de matériaux, simples ou composés, réfractaires ou non, alliés ou non, conducteurs ou diélectriques. Tous les types de substrat qui acceptent une mise sous vide et un léger échauffement peuvent être traités par ce procédé.(....)
Le matériau à déposer appelé matériau cible est introduit dans l'enceinte à vide, sous forme d'une plaque de quelques millimètres d'épaisseur et de dimension sensiblement égale à celle de la pièce à recouvrir. Cette cible est fixée sur une électrode refroidie (la cathode) qu'on porte à une tension négative de 3 à 5 kv. Une deuxième électrode (l'anode) est disposée parallèlement à la cible, à une distance de quelques centimètres. Dans de nombreux cas l'anode sert de porte-substrat, elle est généralement à la masse, ce qui facilite cette utilisation.
Si la pression résiduelle dans l'enceinte est comprise entre 1 Pa et 10² Pa, le champ électrique créé entre les deux électrodes provoque l'ionisation du gaz résiduel. Cette ionisation apparaît sous forme d'un nuage luminescent, localisé entre les deux électrodes(...). Au même moment, un courant électrique s'établit entre les deux électrodes:le gaz résiduel est devenu conducteur, il contient alors:
- des électrons, qui sont attirés par l'anode,
- des ions positifs qui sont attirés par la cible ( la cathode ).

Si on place une pièce devant la cible, on observe que cette pièce se recouvre progressivement d'une couche du même matériau que celui de la plaque constituant la cible. Ce dépôt est dû à la condensation d'atomes provenant de la cible, expulsés de celle-ci sous l'effet de l'impact d'ions positifs contenus dans le gaz luminescent et attirés par la cible du fait de sa polarisation négative."

Une application de cette technique concerne l'électronique:il s'agit du revêtement par un alliage d'aluminium de plaquettes de silicium semi-conducteur("wafers"en anglais).
L'alliage d'aluminium généralement utilisé est un alliage aluminium-silicium contenant de 0,5 à 2% en poids de silicium. La présence du silicium est nécessaire pour diminuer la diffusion du silicium dans l'aluminium et celle de l'aluminium dans le silicium. Ces diffusions, si elles se produisent, créent des contacts de jonctions("spikes" en anglais) qui perturbent les dispositifs actifs des circuits imprimés.
L'aluminium et le silicium doivent être, bien entendu, de haute pureté:99,99 % au moins et en particulier, l'aluminium doit être exempt d'impuretés produisant un rayonnement alpha. En dehors du silicium, qui constitue l'élément d'addition principal de l'alliage, d'autres éléments d'addition peuvent entrer dans la composition de l'alliage.

Une autre caractéristique exigée de ces cibles est que le grain, c'est-à-dire la taille des cristaux métalliques élémentaires constituant la cible soit le plus fin possible. Cela est en effet nécessaire pour assurer une émission régulière des atomes métalliques arrachés à la cible. Or tous les métallurgistes savent qu'il est très difficile d'obtenir un grain fin sur des produits élaborés à partir de métaux extrêmement purs. Les procédés habituels d'affinage du grain de fonderie par addition d'affinants classiques servant de germes, tels le borure de titane, sont, dans le cas présent, complètement prohibés en raison de l'exigence de pureté du métal.

### DESCRIPTION DE L'ART ANTERIEUR

Le procédé généralement pratiqué pour la fabrication des cibles met en application les connaissances de base du spécialiste de la transformation de l'aluminium: lorsque l'aluminium soumis à une déformation à froid ou écrouissage, est ensuite traité thermiquement à une température convenable, le structure cristalline d'origine, dite structure de fonderie, est remplacée par une autre structure cristalline, plus fine et plus régulière. On dit que le métal a recristallisé et la nouvelle structure s'appelle structure de recristallisation.

Le procédé comprend ainsi les étapes suivantes:
1°)Coulée des billettes ou des disques.
   On coule en coulée semi-continue des billettes de diamètre capable de celui de la cible à obtenir. Afin d'obtenir un certain degré d'affinage du grain de fonderie, on procède pendant la coulée à un brassage mécanique de la partie liquide ou marais de la billette coulée en continu. Ce brassage mécanique est fait à l'aide d'un agitateur plongé dans le marais dont la forme, hélice, palette est choisie pour obtenir une efficacité maximale. On admet que l'affinage du grain ainsi réalisé est dû au fractionnement mécanique des dendrites de la phase solide en cours de formation.
   Il est également possible de couler, en moule métallique par exemple, des disques de diamètre capable de celui de la cible à obtenir.
2°)Déformation des tranches de billettes.
   Les billettes sont ensuite découpées en tranches d'épaisseur capable de l'épaisseur finale de la cible. Les disques obtenus ainsi ou directement par moulage subissent alors un certain écrouissage au moyen d'une déformation qui réduit l'épaisseur du disque tout en augmentant de façon homogène ses dimensions dans toutes les directions normales à l'épaisseur. Cette déformation est en général une compression uniaxiale pratiquée à l'aide d'une presse.
3°)Recristallisation
   Le métal du disque ainsi écroui et dont le grain de fonderie a été déformé par écrouissage est donc susceptible de recristallisation. Ce traitement thermique s'opère de façon classique à une température de 300°C à 350°C pendant une durée de 5 minutes à 2 heures.
4°)Résultat obtenu.
   Les disques après le traitement thermique décrit ci-dessus présentent un grain de recristallisation qui n'est pas inférieur à 200 micromètres et dont la taille n'est pas homogène sur tout le volume du disque.
   Les disques, après usinage aux cotes finales, peuvent être utilisées comme cibles pour la pulvérisation cathodique de l'alliage aluminium-silicium.

Ce procédé, largement utilisé, présente cependant deux inconvénients:
- le procédé d'agitation mécanique, même pratiqué avec soin, entraine toujours le risque d'introduction dans le "marais" de la billette coulée en continu d'inclusions d'oxydes.
- le grain obtenu reste encore un peu trop grossier par rapport à ce qui serait souhaitable.

Un procédé pour la fabrication d'une cible en alliage Al-Si, dans lequel la concentration de Si est uniforme dans la cible en resultant, est connu de JP-A-61 124 566.

### EXPOSE DE L'INVENTION

Le procédé objet du brevet se propose de remédier aux deux inconvénients cités ci-dessus. Il consiste en ceci:
1°)-appliquer un traitement thermique particulier aux disques découpés dans la billette ou moulés avant de les déformer pour réduire leur épaisseur tout en augmentant de façon homogène leurs dimensions dans toutes les directions normales à l'épaisseur
2°)-de façon préférentielle, pendant la coulée de la billette, procéder à un brassage électromagnétique du marais de la billette afin d'affiner le grain de fonderie.

Le traitement thermique mis au point se pratique sur les disques découpés dans les billettes obtenues par coulée semi-continue ou coulés en moule. Il comprend plusieurs étapes:
- une étape d'homogénéisation à une température et d'une durée suffisantes pour faire passer la totalité du silicium dont une partie a précipité à la coulée, en solution solide dans l'aluminium, sans cependant brûler l'alliage. Cette opération a pour effet secondaire de faire grossir le grain de fonderie et donc apparemment de nous éloigner de l'objectif recherché:l'obtention d'un grain fin.

Cette étape consiste par exemple, à porter les disques à une température comprise entre 450°C et 570°C, de préférence voisine de 540°C et de les maintenir à cette température pendant une durée supérieure à 4 heures.
- une étape de précipitation du silicium dissous dans la phase aluminium au cours de l'étape précédente. Le précipité de silicium doit être selon l'invention, fin et globulaire. Pour amorcer une telle précipitation, il faut refroidir le métal jusqu'à une zone de température où la solubilité du silicium est suffisamment réduite et selon une loi suffisamment lente pour obtenir la finesse de précipité recherchée. La concentration des précipités de silicium recherchée est comprise entre 10⁵/cm³ et 10¹⁰/cm³. On a trouvé par exemple qu'il fallait refroidir le métal jusqu'à une température comprise entre 330°C et 450°C avec une vitesse comprise entre 10°C et 200°C/heure.
- une étape éventuelle de maintien à la température atteinte à la fin de l'étape de précipitation destinée à parfaire la précipitation et la globulisation des particules de silicium. Ce maintien doit durer un temps suffisant pour que le facteur de forme des précipités de silicium, c'est-à-dire le rapport de leur plus petite à leur plus grande dimension soit compris entre 1 et 0,1. Un tel traitement dure en général plus de 1 heure.
- une dernière étape de refroidissement à la température ambiante à une vitesse comprise entre 5°C/heure et 100°C/heure.

Après ce traitement thermique, objet de l'invention, une déformation et un traitement de recristallisation sont pratiqués comme selon l'art antérieur décrit plus haut.

L'examen micrographique des tranches de billettes traitées selon l'invention permet de constater que la taille du grain est considérablement diminuée par rapport aux tranches traitées selon l'art antérieur. On observe en effet une taille de grain comprise entre 50 et 80 micromètres au lieu des 200 micromètres de l'art antérieur. Il semble que cette diminution notable soit due à la précipitation fine du silicium qui, en créant un grand nombre de germes de recristallisation, limite la croissance des grains.

Une des conditions préférentielles de réalisation de l'invention est la combinaison du traitement thermique décrit ci-dessus avec un brassage électromagnétique du "marais " de la billette pendant la coulée.

En particulier, il a été trouvé que le procédé de brassage électromagnétique décrit dans le brevet français déposé le 19 septembre 1984 sous le n° 84 14740 et délivré le 3 novembre 1986 sous le n° 2570304 est utilisé de préférence en vue d'obtenir la plus grande finesse de grain possible.

Ce procédé consiste à entourer la lingotière de coulée en continu d'une ou plusieurs spires parcourues par un courant monophasé de fréquence industrielle. L'interaction entre le courant induit dans le métal liquide, circulaire et le champ magnétique axial créés par la spire donne naissance à des forces électromagnétiques situés dans des plans méridiens qui ont pour effet d'assurer un brassage du métal dans chacun des plans méridiens de la lingotière.
Ce brassage, ainsi qu'il est indiqué dans le brevet, a pour effet de briser les dendrites formées au voisinage du front de solidification en particules plus fines et de ramener ces particules dans une zône plus chaude où une refusion partielle externe entraine leur globulisation. Le grain est ainsi sensiblement affiné.

Cependant la protection de la présente demande n'est pas limitée à l'utilisation de ce mode de brassage électromagnétique. Elle s'étend à la combinaison du traitement thermique décrit plus haut avec tout type de brassage électromagnétique, par exemple:
- l'utilisation d'une ou plusieurs spires entourant la lingotière et parcourues par des courants monophasés de fréquences différentes, plus faibles ou plus élévées que la fréquence industrielle.
- l'utilisation concomitante d'une lingotière dite à rehausse comportant une partie supérieure chaude dont la paroi est isolante thermiquement et une partie inférieure froide dont la paroi, thermiquement conductrice est refroidie par un fluide et d'une série d'inducteurs constitués de spires annulaires entourant les parties chaude et froide alimentées en courant polyphasé de façon telle que se crèe à l'intérieur du métal liquide un champ alternatif glissant provoquant un brassage énergique du métal dans des plans méridiens de la lingotière. Un tel procédé est décrit dans la demande de brevet français non publiée n°90 00516 appartenant à la demanderesse. L'objet de cette demande est la production de billettes en métal thixotrope, mais le procédé décrit conduisant à un fractionnement des dendrites, donc à un affinage du grain, peut très bien être appliqué, en combinaison avec le traitement thermique décrit ci-dessus à la fabrication de cibles.
- l'utilisation d'un stator de moteur à induction bipolaire créant un champ magnétique tournant dans un plan perpendiculaire à l'axe de la lingotière. Dans ce cas, l'interaction de ce champ avec le courant induit dans le métal génère des forces électromagnétiques non plus situées dans des plans méridiens mais dans des plans horizontaux et tangentielles à la lingotière. Un tel procédé est décrit par exemple dans le brevet français 2 449 499 (ITT INDUSTRIES INC). Là également, l'objectif est la fabrication de métal thixotrope, mais le fractionnement des dendrites conduisant de la même façon à un affinage du grain, ce procédé de coulée peut aussi s'appliquer à la fabrication de cibles.

### DESCRIPTION DE L'INVENTION

L'invention objet de la présente demande sera mieux comprise à l'aide des figures en annexe.

La figure 1 représente le cycle de traitement thermomécanique appliqué dans l'art antérieur.
La figure 2 représente le cycle de traitement thermomécanique appliqué selon l'invention.
La figure 3 représente schématiquement le dispositif de coulée continue utilisé de façon préférentielle selon l'invention.

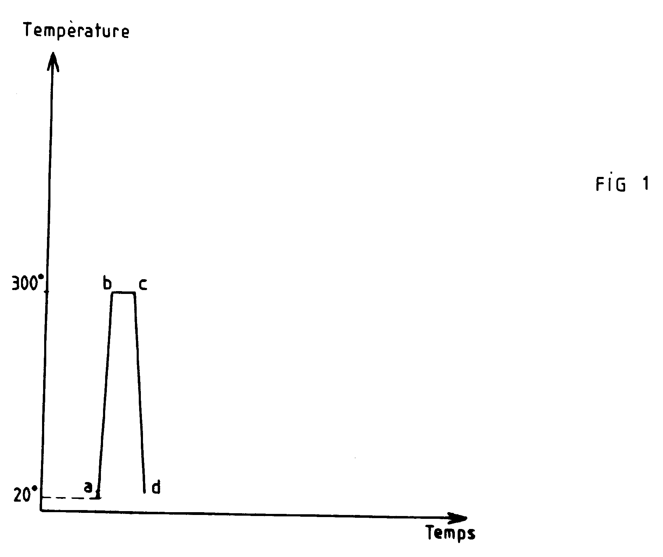

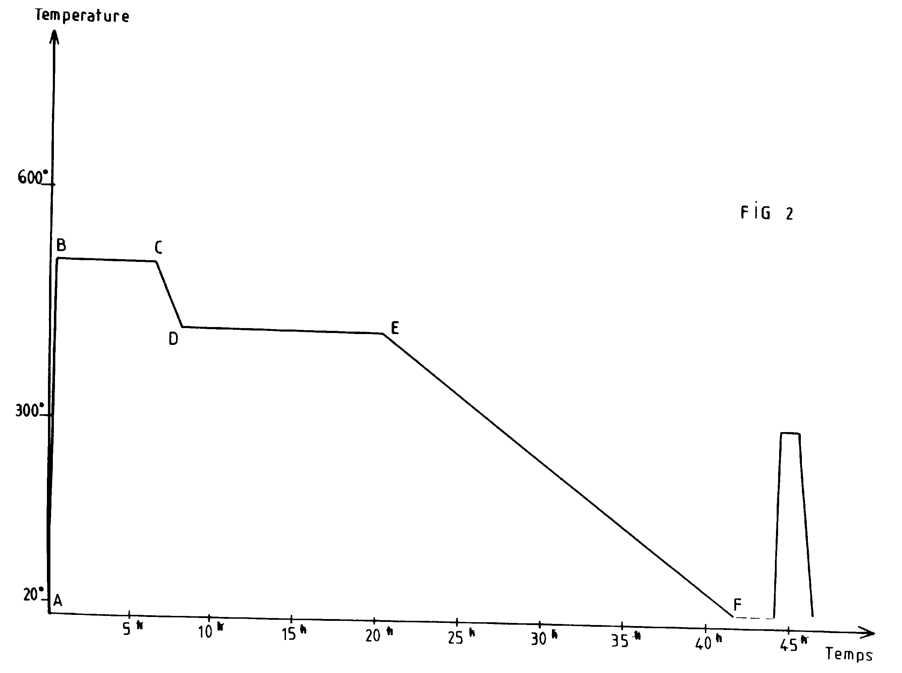

Sur les figures 1 et 2, le temps est porté en abscisses et la température en ordonnées. La partie en pointillé de chacune des deux courbes représente l'écrouissage donné au disque après refroidissement par compression axiale.

Le cycle de la figure 1 est très simple:après l'étape d'écrouissage, l'étape de recristallisation se caractérise par une montée rapide jusqu'à une température comprise entre 300°C et 350°C (courbe a b), puis par un maintien à cette température pendant une durée de 5 minutes à 2 heures (courbe b c). Après quoi, le disque est ramené à la température ambiante par refroidissement par convection naturelle(courbe c d).

Le cycle de la figure 2, selon l'invention, est un peu plus complexe:le disque est porté à la température d'homogénéisation, de 450°C à 570°C (courbe A B), maintenu à cette température pendant une durée supérieure à 4 heures (courbe B C). Le refroidissement contrôlé à une vitesse comprise entre 10°C et 200°C/heure est figuré par la courbe C D. On pratique alors un palier à une température comprise entre 330°C et 450°C d'une durée supérieure à 1 heure (courbe D E), puis on refroidit à la température ambiante à une vitesse comprise entre 5°C et 100°C/Heure (courbe E F). A partir du point F, on reprend les étapes d'écrouissage et de recristallisation de la figure 1.

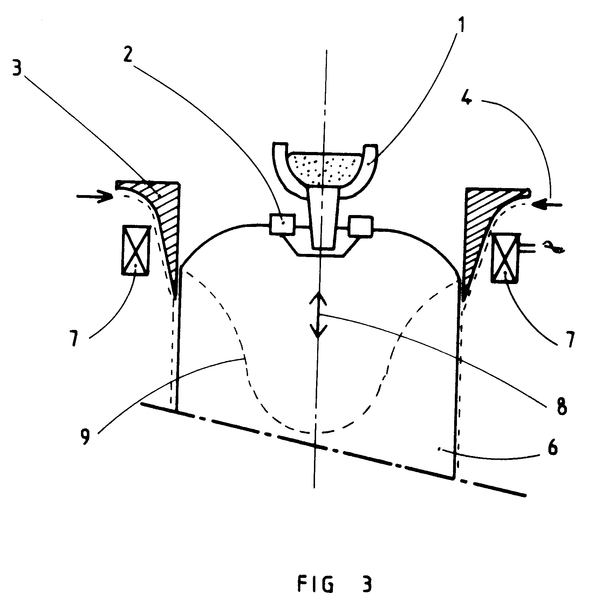

Sur la figure 3, le procédé préférentiel de coulée semi-continue selon l'invention est représenté. On distingue une busette d'alimentation (1) en métal liquide, un flotteur (2) de régulation du niveau, une lingotière (3) refroidie à l'extérieur par un fluide (4) qui ruisselle ensuite sur la billette (6). La lingotière est munie d'un inducteur (7) alimenté sous une tension alternative afin de créer un champ alternatif de direction (8), qui, par interaction avec le courant induit dans la billette, donnera naissance à des forces électromagnétiques provoquant un brassage énergique du métal liquide du marais situé au-dessus du front de solidification (9), et, par conséquent, un affinage du grain.

### EXEMPLE

On a préparé, à partir de silicium et d'aluminium raffinés, un alliage aluminium-silicium contenant 1% en poids de silicium. Cet alliage liquide a été séparé en deux lots. A partir du premier lot, on a coulé une billette de 250 mm de diamètre en coulée semi-continue de façon classique à part le fait que l'on avait placé dans le marais un agitateur rotatif à pales en graphite. La billette obtenue a été découpée en disques de 60 mm d'épaisseur. Chacun de ces disques a été ensuite écrasé à la presse de façon à ramener son épaisseur à 25 mm. Les disques ont alors été soumis à un traitement de recristallisation de une heure à 300°C, puis refroidis à l'ambiante. Le contrôle micrographique du grain a mis en évidence une taille moyenne de grain de 230 micromètres.

A partir du deuxième lot, on a coulé, dans une lingotière entourée d'un inducteur tel que décrit plus haut, une billette de même diamètre. L'inducteur était constitué d'une bobine de 120 tours de fil de cuivre émaillé d'un diamètre de 3,5mm. Son diamètre extérieur était de 330 mm, son diamètre intérieur de 280 mm, sa hauteur de 43 mm. Il était alimenté sous une tension de 100 volts. La billette ainsi obtenue a été découpée en disques de 60 mm d'épaisseur. Chaque disque a été tout d'abord homogénéisé à 540°C pendant 6 heures, puis refroidi jusque 440°C à raison de 60°C/heure. Un palier de 12 heures à 440°C a alors été pratiqué, puis un refroidissement à l'ambiante à raison de 20°C/heure. Chacun de ces disques a été ensuite écrasé à la presse de façon à ramener son épaisseur à 25 mm. Les disques ont alors été soumis à un traitement de recristallisation de une heure à 300°C, puis refroidis à l'ambiante. Le contrôle micrographique du grain a mis en évidence une taille moyenne de grain de 70 micromètres.

## Revendications

1. Procédé de fabrication de cibles à grain fin destinées à la pulvérisation cathodique d'aluminium sous vide comprenant les opérations suivantes:
- élaborer à partir d'aluminium très pur, à 99,99% au moins d'aluminium un alliage aluminium-silicium contenant de 0,05 à 2% de silicium et éventuellement d'autres éléménts d'addition
- couler en semi-continu ou en moule l'alliage ainsi obtenu sous forme de billettes ou de disques
- pratiquer sur les produits ainsi obtenus un traitement thermique d'homogénéisation, de précipitation et éventuellement de globulisation du silicium
- découper éventuellement les billettes en disques
- après refroidissement à une température inférieure à la température de recristallisation, exercer une déformation qui réduit l'épaisseur du produit tout en augmentant de façon homogène ses dimensions dans toutes les directions normales à l'épaisseur
- faire un traitement de recristallisation,
ledit traitement thermique d'homogénéisation, de précipitation et de globulisation comprenant les étapes suivantes:
a) homogénéisation à une température suffisante pour remettre au moins 80% des éléments d'alliage en solution solide sans pour autant brûler l'alliage
b) refroidissement contrôlé à une vitesse ajustée pour amorcer la précipitation du silicium de telle sorte que la concentration de ces précipités soit comprise entre 10⁵/cm³ et 10¹⁰/cm³
c) maintien éventuel à cette dernière température pendant une durée suffisante pour compléter la précipitation et globuliser les précipités jusqu'à ce que leur facteur de forme soit compris entre 0,1 et 1
d) refroidissement contrôlé jusqu'à la température ambiante.

2. Procédé de fabrication de cibles à grain fin destinées à la pulvérisation cathodique d'aluminium sous vide comprenant les opérations suivantes:
- élaborer à partir d'aluminium très pur, à 99,99% au moins d'aluminium un alliage aluminium-silicium contenant de 0,05 à 2% de silicium et éventuellement d'autres éléménts d'addition
- couler en semi-continu ou en moule l'alliage ainsi obtenu sous forme de billettes ou de disques
- pratiquer sur les produits ainsi obtenus un traitement thermique d'homogénéisation, de précipitation et de globulisation du silicium
- découper éventuellement les billettes en disques
- après refroidissement à une température inférieure à la température de recristallisation, exercer une déformation qui réduit l'épaisseur du tout en augmentant de façon homogène ses dimensions dans toutes les directions normales à l'épaisseur
- faire un traitement de recristallisation,
le traitement thermique d'homogénéisation, de précipitation et de globulisation comprenant les étapes suivantes:
a) homogénéisation à une température comprise entre 450° et 570° et de préférence voisine de 540° pendant une durée supérieure à 4 heures
b) refroidissement contrôlé à une vitesse comprise entre 10°C/ heure et 200°C/heure jusqu'à une température fixée et comprise entre 330°C et 450°C
c) maintien à cette dernière température pendant une durée supérieure à 1 heure
d) refroidissement contrôlé à une vitesse comprise entre 5°C/heure et 100°C/heure jusqu'à la température ambiante.

3. Procédé de fabrication de cibles à grain fin destinées à la pulvérisation cathodique d'aluminium sous vide selon l'une des revendications 1 ou 2 caractérisé en ce que, afin d'obtenir un affinage du grain de fonderie, un brassage électromagnétique est appliqué à l'alliage aluminium-silicium à l'intérieur de la lingotière de coulée continue.

4. Procédé de fabrication de cibles à grain fin destinées à la pulvérisation cathodique d'aluminium sous vide selon la revendication 3 caractérisé en ce que le brassage électromagnétique est obtenu par application d'un champ magnétique d'intensité variable et sensiblement parallèle à l'axe de la lingotière.

5. Procédé de fabrication de cibles à grain fin destinées à la pulvérisation cathodique d'aluminium sous vide selon la revendication 4 caractérisé en ce que le champ magnétique est obtenu à l'aide d'une ou plusieurs spires disposées autour de la lingotière et alimentées en courant alternatif de fréquence industrielle.

6. Cible à grain fin en alliage aluminium-silicium à haute pureté destinée à la pulvérisation cathodique d'aluminium sous vide caractérisée en ce que la taille du grain est inférieure à 100 micromètres.

## Patentansprüche

1. Verfahren zur Herstellung von Scheiben mit feinem Korn, die zur kathodischen Zerstäubung von Aluminium unter Vakuum bestimmt sind, das die folgenden Arbeitsschritte aufweist:
- Erzeugung einer 0,05 bis 2 % Silizium und eventuell andere Zusatzelemente enthaltenden Aluminium-Silizium-Legierung ausgehend von sehr reinem Aluminium mit wenigstens 99,99 % Aluminium
- halbkontinuierlicher oder Formguß der so erhaltenen Legierung in Form von Knüppeln oder Scheiben
- Durchführung einer Wärmehomogenisierungs-, Ausscheidungs- und eventuell Siliziumkugelbildungsbehandlung der so erhaltenen Produkte
- eventuell Zerschneidung der Knüppel zu Scheiben
- nach Abkühlung auf eine Temperatur unter der Rekristallisationstemperatur Vornahme einer Verformung, die die Dicke des Produkts bei gleichzeitiger homogener Vergrößerung seiner Abmessungen in allen zur Dicke senkrechten Richtungen verringert
- Durchführung einer Rekristallisationsbehandlung, welche Wärmehomogenisierungs-, Ausscheidungs- und Kugelbildungsbehandlung die folgenden Schritte aufweist:
a) Homogenisierung bei einer ausreichenden Temperatur, um wenigstens 80 % der Legierungselemente in feste Lösung zu bringen, ohne jedoch die Legierung zu brennen
b) gesteuerte Abkühlung mit einer justierten Geschwindigkeit, um die Ausscheidung des Siliziums derart auszulösen, daß die Konzentration dieser Ausscheidungen im Bereich von 10⁵/cm³ bis 10¹⁰/cm³ liegt
c) eventuelles Halten bei dieser letzteren Temperatur während einer ausreichenden Dauer, um die Ausscheidung zu vervollständigen und die Ausscheidungen zu globulisieren, bis ihr Formfaktor im Bereich von 0,1 bis 1 ist
d) gesteuerte Abkühlung bis zur Umgebungstemperatur.

2. Verfahren zur Herstellung von Scheiben mit feinem Korn, die zur kathodischen Zerstäubung von Aluminium unter Vakuum bestimmt sind, das die folgenden Arbeitsschritte aufweist:
- Erzeugung einer 0,05 bis 2 % Silizium und eventuell andere Zusatzelemente enthaltenden Aluminium-Silizium-Legierung ausgehend von sehr reinem Aluminium mit wenigstens 99,99 % Aluminium
- halbkontinuierlicher oder Formguß der so erhaltenen Legierung in Form von Knüppeln oder Scheiben
- Durchführung einer Wärmehomogenisierungs-, Ausscheidungs- und eventuell Siliziumkugelbildungsbehandlung der so erhaltenen Produkte
- eventuell Zerschneidung der Knüppel zu Scheiben
- nach Abkühlung auf eine Temperatur unter der Rekristallisationstemperatur Vornahme einer Verformung, die die Dicke des Produkts bei gleichzeitiger homogener Vergrößerung seiner Abmessungen in allen zur Dicke senkrechten Richtungen verringert
- Durchführung einer Rekristallisationsbehandlung, welche Wärmehomogenisierungs-, Ausscheidungs- und Kugelbildungsbehandlung die folgenden Schritte aufweist:
a) Homogenisierung bei einer Temperatur im Bereich von 450° bis 570° und vorzugsweise nahe 540° während einer Dauer über 4 Stunden
b) gesteuerte Abkühlung mit einer Geschwindigkeit im Bereich von 10 °C/Stunde bis 200 °C/Sunde bis zu einer festgesetzten Temperatur im Bereich von 330 °C bis 450 °C
c) Halten bei dieser letzten Temperatur während einer Dauer von über 1 Stunde
d) gesteuerte Abkühlung mit einer Geschwindigkeit im Bereich von 5 °C/Stunde bis 100 °C/Stunde bis zur Umgebungstemperatur.

3. Verfahren zur Herstellung von Scheiben mit feinem Korn. die zur kathodischen Zerstäubung von Aluminium unter Vakuum bestimmt sind, nach einem der Ansprüche 1 und 2,
dadurch gekennzeichnet,
daß zur Erzielung eines Affinierens des Gießereikorns ein elektromagnetisches Rühren auf die Aluminium-Silizium-Legierung im Inneren der Stranggußform angewandt wird.

4. Verfahren zur Herstellung von Scheiben mit feinem Korn, die zur kathodischen Zerstäubung von Aluminium unter Vakuum bestimmt sind, nach dem Anspruch 3,
dadurch gekennzeichnet,
daß das elektromagnetische Rühren durch Einwirkung eines Magnetfeldes variabler Stärke erfolgt, das zur Achse der Form im wesentlichen parallel ist.

5. Verfahren zur Herstellung von Scheiben mit feinem Korn. die zur kathodischen Zerstäubung von Aluminium unter Vakuum bestimmt sind, nach dem Anspruch 4,
dadurch gekennzeichnet,
daß das Magnetfeld mit Hilfe einer oder mehrerer Windungen erhalten wird, die um die Form herum angeordnet sind und mit Wechselstrom von Industriefrequenz gespeist werden.

6. Scheibe mit feinem Korn aus Aluminium-Silizium-Legierung hoher Reinheit, die zur kathodischen Zerstäubung von Aluminium unter Vakuum bestimmt ist,
dadurch gekennzeichnet,
daß die Abmessung des Korns unter 100 Mikrometer ist.

## Claims

1. Process for the production of fine grain targets for the vacuum cathodic sputtering of aluminium comprising the following operations:
- producing from highly pure and at least 99.99% aluminium, an aluminium-silicon alloy containing 0.05 to 2% silicon and optionally other addition elements,
- casting the thus obtained alloy semicontinuously or in a mould in the form of billets or disks,
- carrying out on the thus obtained products a thermal homogenization, precipitation and optionally spheroiding treatment with respect to the silicon,
- optionally cutting the billets into disks,
- after cooling to a temperature below the recrystallization temperature carrying out a deformation reducing the thickness of the product whilst uniformly increasing its dimensions in all directions perpendicular to the thickness,
- performing a recrystallization treatment,
said thermal homogenization, precipitation and spheroiding treatment comprising the following stages:
a) homogenizing at an adequate temperature to return at least 80% of the alloying elements into a solid solution without burning the alloy,
b) controlled cooling at an adjusted speed in order to initiate the precipitation of the silicon in such a way that the concentration of its precipitates is between 10⁵/cm³ and 10¹⁰/cm³,
c) optionally maintaining at said latter temperature for a time sufficient to complete the precipitation and spheroiding the precipitates until their shape factor is between 0.1 and 1,
d) controlled cooling to ambient temperature.

2. Process for the production of fine grain targets for the vacuum cathodic sputtering of aluminium comprising the following operations:
- producing from highly pure and at least 99.99% aluminium, an aluminium-silicon alloy containing 0.05 to 2% silicon and optionally other addition elements,
- casting the thus obtained alloy semicontinuously or in a mould in the form of billets or disks,
- carrying out on the thus obtained products a thermal homogenization, precipitation and optionally spheroiding treatment with respect to the silicon,
- optionally cutting the billets into disks,
- after cooling to a temperature below the recrystallization temperature carrying out a deformation reducing the thickness of the product whilst uniformly increasing its dimensions in all directions perpendicular to the thickness,
- performing a recrystallization treatment,
said thermal homogenization, precipitation and spheroiding treatment comprising the following stages:
a) homogenizing at a temperature between 450 and 570°C and preferably close to 540°C for a time exceeding 4 hours,
b) controlled cooling at a rate between 10°C and 200°C/hour to a fixed temperature between 330 and 450°C,
c) maintaining at the latter temperature for a time exceeding 1 hour,
d) controlled cooling at a rate between 5°C and 100°C/hour to ambient temperature.

3. Process for the production of fine targets for the vacuum cathodic sputtering of aluminium according to claims 1 or 2, characterized in that, in order to obtain a refining of the foundry grain, electromagnetic stirring is applied to the aluminium-silicon alloy within the continuous casting ingot mould.

4. Process for the production of fine grain targets for vacuum cathodic sputtering of aluminium according to claim 3, characterized in that the electromagnetic stirring is obtained by applying a variable intensity magnetic field substantially parallel to the axis of the ingot mould.

5. Process for the production of fine grain targets for vacuum cathodic sputtering of aluminium according to claim 4, characterized in that the magnetic field is obtained with the aid of one or more coils placed around the ingot mould and supplied with alternating current at an industrial frequency.

6. High purity, aluminium-silicon alloy, fine grain target for the vacuum cathodic sputtering of aluminium, characterized in that the size of the grain is below 100 micrometers.
